# EUROPÄISCHE PATENTANMELDUNG

(11) **EP 0 833 452 A1**
(43) Veröffentlichungstag der Anmeldung: **01.04.1998**
(21) Anmeldenummer: 97202867.4
(22) Anmeldetag: 18.09.1997
(51) Int. Cl.: H03L 7/089, H04N 5/44

(54) **Phasenregelkreis**

(30) Priorität: 25.09.1996 DE 19639370
(71) Anmelder: Philips Patentverwaltung GmbH, 22335 Hamburg (DE); Philips Electronics N.V., 5621 BA Eindhoven (NL)
(72) Erfinder: Meyer, Robert, Röntgenstrasse 24, 22335 Hamburg (DE)
(74) Vertreter: von Laue, Hanns-Ulrich, Dipl.-Ing.

(57) **Zusammenfassung**

Für einen Phasenregelkreis mit einem Phasendetektor (1), einem Integralregler, einen Porportionalregler und einem gesteuerten Oszillator (3) ist zur möglichst einfachen Integration der Schaltung und für ein gleichzeitig gutes Regelverhalten vorgesehen, daß der Integralregler mittels einer Integrationskapazität (2) realisiert ist, welche zwischen ein Versorgungspotential und eine Signalstrecke geschaltet ist, welche einen Stromquellenausgang (6) des Phasendetektors (1) mit einem Eingang des gesteuerten Oszillators (3) koppelt, und daß der Proportionalregler mittels Spannungsimpulsen realisiert ist, welche in die Signalstrecke zwischen dem Ausgang (6) des Phasendetektors (1) und dem Eingang des gesteuerten Oszillators (3) kapazitiv eingekoppelt werden.

## Beschreibung

Die Erfindung betrifft einen Phasenregelkreis mit einem Phasendetektor, einem Integralregler, einem Proportionalregler und einem gesteuerten Oszillator.

In einem Phasenregelkreis, der englisch als phase locked loop (PLL) bezeichnet wird, bestimmt das zwischen den Phasendetektor und den gesteuerten Oszillator geschaltete Schleifenfilter dessen Regelverhalten. Das Schleifenfilter besteht meist bezüglich des Regelverhaltens aus einem Integralregler und einem Proportionalregler. In konventioneller Bauweise wird der Integralregler mittels einer Kapazität und der Proportionalregler mittels eines Widerstandes erzeugt, die in Reihe geschaltet gegen ein festes Potential geschaltet werden. Soll der Phasenregelkreis auf einem integrierten Schaltkreis realisiert werden, ergeben sich bezüglich des Widerstandes Probleme, da ein Widerstand in einem integrierten Schaltkreis nur mit hohem Flächenbedarf und relativ großer Ungenauigkeit bezüglich seines Widerstandswertes zu realisieren ist. In einer bekannten Lösung, die beispielsweise in dem PHILIPS IC-Typ SAA 7111 realisiert ist, werden daher zur Erzeugung des Proportionalanteils Stromimpulse auf einen Steuereingang des steuerbaren Oszillators eingekoppelt, der in Abhängigkeit der Stromimpulse die Frequenz des Oszillators variiert. Der gesteuerte Oszillator weist einen weiteren Eingang auf, der mit dem Ausgang des Phasendetektors gekoppelt und der zur Erzeugung des Integralanteils gegen ein Versorgungspotential gekoppelten Kapazität gekoppelt ist und der spannungssensitiv ist.

Diese Schaltung setzt zum einem voraus, daß der gesteuerte Oszillator einen spannungs- und einen stromabhängigen Eingang aufweisen muß. Darüber hinaus tritt der Nachteil auf, daß die eingekoppelten Stromimpulse nur mit begrenzter Steilheit erzeugt werden können. Insbesondere Stromimpulse weisen nahezu zwangweise in realen Schaltungen eine Anstiegsflanke auf, die etwa nach einer e-Funktion verläuft. Damit ergeben sich bezüglich der Erzeugung des Proportionalanteils Nachteile, da ein schnelles Regelverhalten der PLL infolge der verschliffenen Flanken der Stromimpulse bei ausreichender Dämpfung der PLL nicht erzielt werden kann.

Es ist Aufgabe der Erfindung, einen Phasenregelkreis der eingangs genannten Art anzugeben, welcher ohne Nachteile voll integrierbar ist und dennoch ein gutes Regelverhalten aufweist.

Diese Aufgabe ist erfindungsgemäß dadurch gelöst, daß der Integralregler mittels einer Integrationskapazität realisiert ist, welche zwischen ein Versorgungspotential und eine Signalstrecke geschaltet ist, welche einen Strom-Ausgang des Phasendetektors mit einem Eingang des gesteuerten Oszillators koppelt, und daß der Proportionalregler mittels Spannungsimpulsen realisiert ist, welche in die Signalstrecke zwischen dem Ausgang des Phasendetektors und dem Eingang des gesteuerten Oszillators eingekoppelt werden.

Der Integralregler kann auch in integrierten Schaltkreisen ohne Nachteil als Kapazität realisiert werden. Diese Integrationskapazität ist einerseits auf die Signalstrecke zwischen dem Strom-Ausgang des Phasendetektors und dem Eingang des gesteuerten Oszillators gekoppelt. Andererseits ist sie gegen ein Versorgungspotential gekoppelt.

Der Proportionalregler ist mittels Spannungsimpulsen realisiert, die der Phasendetektor liefert. Diese Spannungsimpulse werden in die Signalstrecke zwischen dem Strom-Ausgang des Phasendetektors und dem Eingang des gesteuerten Oszillators eingekoppelt. Dieser Proportionalregler ist in integrierten Schaltkreisen auf einfache Weise zu erzeugen, da für ihn nur Transistoren und Kapazitäten erforderlich sind.

Bezüglich des Regelverhaltens ergeben sich Vorteile, da Spannungsimpulse wesentlich einfacher mit steilen Flanken zu generieren sind als dies bei Stromimpulsen der Fall ist. Damit können steilflankige Spannungsimpulse eingesetzt werden, die ein schnelles Regelverhalten der PLL ermöglichen.

Es vereinfacht sich der Aufbau des gesteuerten Oszillators, da er nur noch einen spannungsabhängigen Eingang aufweisen muß, auf den sowohl der Integralregler als auch der Proportionalregler wirken.

Gemäß einer Ausgestaltung der Erfindung ist vorgesehen, daß der Phasendetektor Spannungsquellen aufweist, deren Ausgangssignale über gesteuerte Schalter zur Realisierung des Proportionalreglers für beide Polaritäten getrennt über je eine Koppelkapazität auf die Signalstrecke zwischen dem Strom-Ausgang des Phasendetektors mit dem Eingang des gesteuerten Oszillators eingekoppelt werden. Innerhalb des Phasendetektors können die Impulse zur Erzeugung des Proportionalanteils mittels Invertern erzeugt werden, die einfach zu realisieren sind. Die Ausgangssignale der Spannungsquellen werden über je eine Kapazität auf die Signalstrecke zwischen dem Ausgang des Phasendetektors und dem Eingang des gesteuerten Oszillators gekoppelt, so daß die Impulse entsprechende Spannungsabfälle an den Kapazitäten erzeugen, die den Proportionalanteil in die Signalstrecke einkoppeln.

Gemäß einer weiteren Ausgestaltung der Erfindung ist vorgesehen, daß die Signalstrecke den Ausgang des Phasenkomparators mit einem am Eingang des gesteuerten Oszillators vorgesehenen Spannungs-/Strom-Wandler koppelt, in Abhängigkeit von dessen Ausgangssignal der Oszillator die Frequenz seines Ausgangssignals variiert.

Ist der gesteuerte Oszillator so aufgebaut, daß er eingangsseitig einen Spannungs-/Strom-Wandler aufweist, in Abhängigkeit von dessen Strom-Ausgangssignal der eigentliche Oszillator gesteuert wird, so wird der Spannungseingang des Spannungs-/Strom-Wandlers vorteilhaft mit dem Strom-Ausgang des Phasenkomparators, der Integrationskapazität des Integrationsreglers und den Spannungsimpulsen des Proportionalreglers gekoppelt, die sämtlich spannungsgesteuerte Signale liefern bzw. darstellen.

Nachfolgend wird ein Ausführungsbeispiel der Erfindung anhand der Zeichnung näher erläutert. Es zeigen:
Fig. 1 ein Blockschaltbild eines Phasenregelkreises mit einem Phasendetektor, einem Integralregler, einem Proportionalregler und einem spannungsgesteuerten Oszillator und
Fig. 2 ein über der Zeit dargestelltes Spannungssignal, wie es in der Schaltungsanordnung gemäß Fig. 1 durch Überlagerung der Spannungssignale des Integralreglers und des Proportionalreglers auftritt.

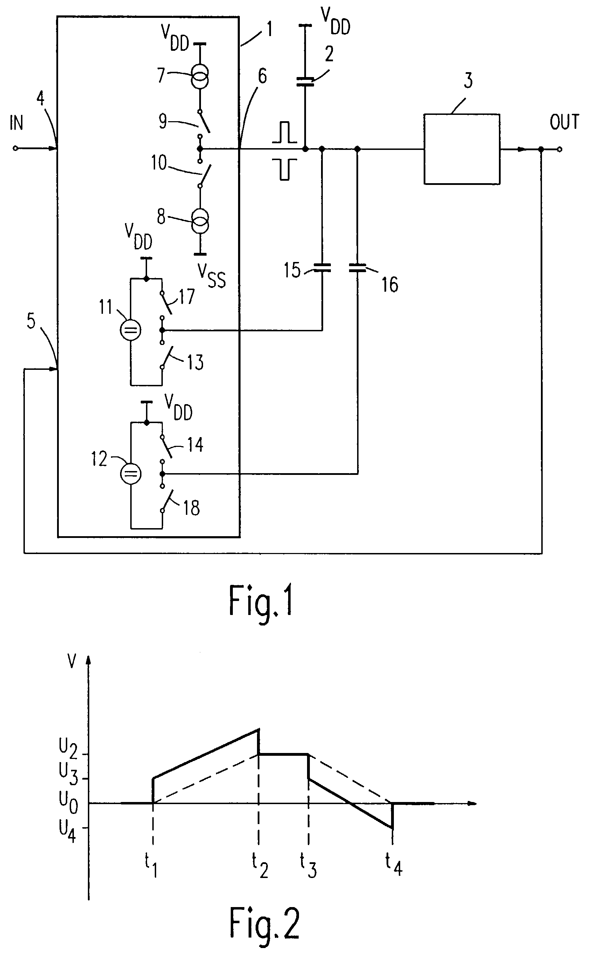

Der in Fig. 1 in Form eines Blockschaltbildes dargestellte Phasenregelkreis weist einen Phasendetektor 1, eine Integrationskapazität 2 und einen gesteuerten Oszillator 3 auf.

Dem Phasendetektor 1 wird an einem ersten Eingang 4 ein mit IN bezeichnets Eingangssignal zugeführt, in Abhängigkeit dessen der in der Figur dargestellte Phasenregelkreis gesteuert wird.

An einem zweiten Eingang 5 wird dem Phasendetektor 1 ein Ausgangssignal des gesteuerten Oszillators 3 zugeführt.

Ist in der Schaltungsanordnung, wie es in dem Beispiel gemäß Fig. 1 der Fall ist, kein Teiler vorgesehen, so soll die Frequenz des Ausgangssignals des gesteuerten Oszillators 3 auf die Frequenz des Eingangssignals IN am ersten Eingang 4 des Phasendetektors 1 synchronisiert werden.

Dazu liefert der Phasendetektor 1 an einem ersten Ausgang 6 Stromimpulse verschiedener Polarität, welche auf eine Integrationskapazität 2 gekoppelt werden und diese laden bzw. entladen. Die Integrationskapazität 2 ist gegen ein Versorgungspotential V_{DD} gekoppelt. Wie in der Fig. 1 angedeutet ist, werden die Stromimpulse mittels Stromquellen 7 bzw. 8 generiert, welche gegen das Versorgungspotential V_{DD} bzw. ein Bezugspotential V_{SS} gekoppelt sind. Mittels in der Figur nur schematisch dargestellten Schaltern 9 bzw. 10 wird eine der Stromquellen kurzzeitig auf den Ausgang 6 des Phasendetektors 1 geschaltet. Dies geschieht in Abhängigkeit der Phasenbeziehungen der Eingangssignale an den beiden Eingängen 4 und 5 des Phasendetektors 1. Tritt zwischen den Eingangssignalen an diesen beiden Eingängen eine Phasenverschiebung auf, wird in Abhängigkeit von deren Vorzeichen entweder die Stromquelle 7 oder die Stromquelle 8 kurzzeitig auf den Ausgang 6 des Phasendetektors 1 geschaltet. Die auf diese Weise erzeugten Stromimpulse laden die Integrationskapazität 2 mit dem entsprechenden Vorzeichen auf. Damit baut sich über der Integrationskapazität 2 eine entsprechende Spannung auf, die ebenfalls am Eingang des gesteuerten Oszillators 3 auftritt und diesen bezüglich der Frequenz seines Ausgangssignals steuert. Damit ist mittels der Stromquellen 7 und 8 und der Integrationskapazität 2 der Integralregler realisiert.

Der Proportionalregler ist erfindungsgemäß dadurch realisiert, daß in die Signalstrecke zwischen dem Ausgang 6 des Phasendetektors 1 und dem Eingang des gesteuerten Oszillators 3 Spannungsimpulse eingekoppelt werden. In der Realisierung gemäß Fig. 1 sind dazu Spannungsquellen 11 bzw. 12 vorgesehen, welche gegen das Versorgungspotential V_{DD} und gegebenenfalls gegen das Bezugspotential V_{SS} geschaltet sind.

Die Spannungsquelle 11 ist mittels zweier in der Figur schematisch dargestellter gesteuerter Schalter 13 und 17 über eine Koppelkapazität 15 auf die Signalstrecke zwischen dem Ausgang 6 des Phasendetektors 1 und dem Eingang des gesteuerten Oszillators 3 schaltbar. Werden die gesteuerten Schalter 13 und 17 geschlossen, so wird über die Koppelkapazität 15 ein positiver Spannungsimpuls auf die Signalstrecke gekoppelt.

In entsprechender Weise ist eine Spannungsquelle 12 über zwei steuerbare Schalter 14 und 18 und eine Koppelkapazität 16 auf diese Signalstrecke schaltbar. Auch hier gilt, daß in Abhängigkeit der Phasenbeziehungen der Eingangssignale des Phasendetektors 1 und in Abhängigkeit von deren Vorzeichen entweder die Spannungsquelle 11 oder die Spannungsquelle 12 mittels der zugeordneten Schalter 13 und 17 bzw. 14 und 18 aktiviert werden. Die Schalter 13, 17, 14 und 18 können auch als Inverter realisiert werden, welche über die Spannungsquelle 11 bzw. 12 versorgt werden.

Im Gegensatz zu der Integrationskapazität 2, die zur Erzeugung des Integralanteils relativ große Werte aufweist, weisen die Koppelkapazitäten 15 und 15 kleine Werte auf. Diese Kapazitäten 15 und 16 dienen dazu, in Abhängigkeit der Ausgangssignale der Spannungsquellen 11 bzw. 12 entsprechende Spannungssignale in die Signalstrecke zwischen dem Ausgang 6 des Phasendetektors 1 und dem Eingang des gesteuerten Oszillators 3 einzukoppeln.

Damit ist eine Realisierung des Proportionalanteils ohne Widerstand gelungen. Die in die Signalstrecke eingekoppelten Spannungsimpulse können sehr steilflankig sein, so daß das dynamische Verhalten der PLL auch bei kleinen Phasenfehlern wunschgemäß über den Grad der Einkopplung der Spannungsimpulse eingestellt werden kann.

In Fig. 2 ist ein Spannungssignal über der Zeit dargestellt, wie es am Eingang des gesteuerten Oszillators 3 auftreten kann, wenn die Eingangssignale des Phasendetektors 1 eine Phasenverschiebung relativ zueinander aufweisen zunächst positiv und danach negativ ist. Der Phasendetektor 1 kann digital arbeiten und dabei beispielsweise immer nur die relative Lage der Vorderflanken der beiden ihm zugeführten Eingangssignale auswerten. Taucht die Vorderflanke beispielsweise des ersten Signales eher auf, so liegt eine Regelabweichung in einer ersten Richtung vor, bei der der Phasendetektor beispielsweise positive Strom- und Spannungsimpulse an seinen Ausgang liefert. Erscheint hingegen die Vorderflanke des ersten Signales später als diejenige des zweiten Signals, so handelt es sich um eine negative Phasenabweichung, die den Phasendetektor 1 veranlaßt, an seinen Ausgängen negative Strom- bzw. Spannungsimpulse zu liefern.

Das in Fig. 2 über der Zeit dargestellte Spannungssignal, wie es am Eingang des gesteuerten Oszillators 3 erscheint, weist zum Zeitpunkt t₁ einen Wert U₀ auf. Bis zu diesem Zeitpunkt sind die Eingangssignale an den beiden Eingängen des Phasendetektors 1 gemäß Fig. 1 in Phase. Ab dem Zeitpunkt t₁ tritt ein Spannungssprung auf, der gefolgt wird von einem linearen Anstieg der Spannung bis zum Zeitpunkt t₂. Zum Zeitpunkt t₂ tritt der zum Zeitpunkt t₁ aufgetretene Spannungssprung mit umgekehrtem Vorzeichen wieder auf. Der lineare Anstieg zwischen den Zeitpunkten t₁ bis t₂ wird von dem Integralregler erzeugt, also der Spannung, die über der Integrationskapazität 2 abfällt. Diese wiederum wird erzeugt durch entsprechende Ladeströme des Stromausgangs 6 des Phasendetektors 1. Der zu dem Zeitpunkt t₁ eingeschaltete und zum Zeitpunkt t₂ ausgeschaltete Spannungsprung wird von dem Proportionalregler erzeugt. Dessen Anteil ist in der Figur zwischen den Zeitpunkten t₁ und t₂ durch eine gestrichelte Linie angedeutet.

Dieser Spannungssprung, der den Proportionalanteil darstellt, wird zwischen den Zeitpunkten t₁ und t₂ dadurch erzeugt, daß die Spannungsquelle 11 mittels der gesteuerten Schalter 13 und 17 vom Zeitpunkt t₁ bis zum Zeitpunkt t₂ auf die Signalstrecke zwischen dem Ausgang 6 des Phasendetektors 1 und dem Eingang des gesteuerten Oszillators 3 geschaltet wird. Dadurch wird ein entsprechendes Spannungssignal auf diesen Eingang gekoppelt. Um diesen Spannungsimpuls zur Erzeugung des Proportionalanteils vom Zeitpunkt t₁ bis zum Zeitpunkt t₂ einzukoppeln, wird zum Zeitpunkt t₁ der Schalter 13 geöffnet und der Schalter 17 geschlossen. Zum Zeitpunkt t₂ wird der Schalter 17 geöffnet und der Schalter 13 wieder geschlossen.

Die Steigung des Signals zwischen den Zeitpunkten t₁ und t₂ wird hingegen durch den Integralregler bestimmt. In der Schaltungsanordnung gemäß Fig. 1 ist zwischen den Zeitpunkten t₁ und t₂ der gesteuerte Schalter geschlossen, so daß die Stromquelle 7 die Integrationskapazität 2 auflädt und am Eingang des gesteuerten Oszillators 3 ein entsprechender Anstieg der Spannung auftritt.

In der Darstellung gemäß Fig. 2 überlagern sich die Spannungsanteile des Integralreglers und des Proportionalreglers.

In dem Beispiel gemäß Fig. 2 wird davon ausgegangen, daß die beiden Eingangssignale des Phasendetektors 1 gemäß Fig. 1 sich ab dem Zeitpunkt t₂ wieder in Phase befinden. Damit sind die gesteuerten Schalter 9, 10, 17 und 18 der Schaltungsanordnung gemäß Fig. 1 geöffnet und die Schalter 13 und 14 geschlossen. Der Proportionalanteil tritt ab dem Zeitpunkt t₂ nicht mehr auf, was durch die zu diesem Zeitpunkt auftretende negative Flanke in dem Spannungssignal gemäß Fig. 2 verdeutlicht wird. Jedoch bleibt die Integrationskapazität auf dem zu diesem Zeitpunkt erreichten Wert U₂ geladen, so daß das Signal ab diesem Zeitpunkt bis zum Zeitpunkt t₃ auf der Höhe des Spannungsabfalles bleibt, der über der Integrationskapazität 2 der Anordnung gemäß Fig. 1 auftritt.

Für den Verlauf des Spannungssignals gemäß Fig. 2 wird davon ausgegangen, daß ab dem Zeitpunkt t₃ dieses Signals die beiden Eingangssignale des Phasendetektors gmeäß Fig. 1 sich nicht mehr in Phase befinden und daß die Phasenverschiebung dieser Signale nun, verglichen mit der Phasenbeziehung zwischen den Zeitpunkten t₁ und t₂, mit umgekehrtem Vorzeichen auftritt. Der Phasenfehler ist nun negativ.

Zur Erzeugung des Integralanteils wird der Schalter 10 geschlossen, so daß die Stromquelle 8 der Schaltungsanordnung gemäß Fig. 1 die Integrationskapazität 2 nunmehr mit umgekehrtem Vorzeichen lädt bzw. diese entlädt. Gleichzeitig wird zur Erzeugung des Proportionalanteils der Schalter 14 geöffnet und der Schalter 18 geschlossen, so daß das Ausgangssignal der Spannungsquelle 12 über die Koppelkapazität 16 auf die Verbindung zwischen dem Ausgang 6 des Phasendetektors und dem Eingang des gesteuerten Oszillators 3 gekoppelt wird. In Fig. 2 ist dieser negative Spannungsimpuls zwischen den Zeitpunkten t₃ und t₄ erkennbar.

Zwischen den Zeitpunkten t₃ und t₄ wird die Integrationskapazität wieder entladen, so daß zum Zeitpunkt t₄ in dem Beispielsfall gemäß Fig. 2 eine Spannung U₄ auftritt, die in dem Beispielsfall gemäß Fig. 2 gleich U₀ ist und die niedriger ist als die Spannung U₂. Ab dem Zeitpunkt t₄ befinden sich die Eingangssignale des Phasendetektors 1 wieder in Sollphasenlage.

Das Spannungssignal gemäß Fig. 2, wie es am Eingang des gesteuerten Oszillators 3 in diesem Beispielsfalle auftritt, zeigt die Spannungsimpulse des Proportinalreglers und des Integralreglers in überlagerter Form. Hierbei wird deutlich, daß insbesondere der Proportionalanteil aufgrund der erfindungsgemäßen Schaltung sehr steilflankig erzeugt werden kann, ohne daß hierfür der Einsatz eines Widerstandes erforderlich ist. Infolge dieser steilen Flanken kann das Regelverhalten wunschgemäß eingestellt werden.

## Patentansprüche

1. Phasenregelkreis mit einem Phasendetektor (1), einem Integralregler, einem Proportionalregler und einem gesteuerten Oszillator (3),
dadurch gekennzeichnet,
daß der Integralregler mittels einer Integrationskapazität (2) realisiert ist, welche zwischen ein Versorgungspotential und eine Signalstrecke geschaltet ist, welche einen Strom-Ausgang (6) des Phasendetektors (1) mit einem Eingang des gesteuerten Oszillators (3) koppelt, und daß der Proportionalregler mittels Spannungsimpulsen realisiert ist, welche in die Signalstrecke zwischen dem Ausgang (6) des Phasendetektors (1) und dem Eingang des gesteuerten Oszillators (3) kapazitiv eingekoppelt werden.

2. Phasenregelkreis nach Anspruch 1, dadurch gekennzeichnet, daß der Phasendetektor Spannungsquellen (11,12) aufweist, deren Ausgangssignale über gesteuerte Schalter (13, 17,14, 18) zur Realisierung des Proportionalreglers für beide Polaritäten getrennt über je eine Koppelkapazität (15,16) auf die Signalstrecke zwischen dem Ausgang (6) des Phasendetektors (1) mit dem Eingang des gesteuerten Oszillators (3) eingekoppelt werden.

3. Phasenregelkreis nach Anspruch 1 oder 2, dadurch gekennzeichnet, daß die Signalstrecke den Ausgang (6) des Phasenkomparators (1) mit einem am Eingang des gesteuerten Oszillators (3) vorgesehenen Spannungs-/Strom-Wandler koppelt, in Abhängigkeit von dessen Ausgangssignal der Oszillator (3) die Frequenz seines Ausgangssignals variiert.

4. Phasenregelkreis nach einem der Ansprüche 1 bis 3, dadurch gekennzeichnet, daß zwischen den Ausgang des gesteuerten Oszillators und den einen Eingang (5) des Phasendetektors (1) ein Frequenzteiler geschaltet ist.

5. Phasenregelkreis nach einem der Ansprüche 1 bis 4, dadurch gekennzeichnet, daß die Spannungsquellen (11, 12) als steuerbare Spannungsquellen realisiert sind.

6. Phasenregelkreis nach einem der Ansprüche 1 bis 5, dadurch gekennzeichnet, daß die gesteuerten Schalter (13, 17, 14, 18) als gesteuerte Inverter realisiert sind.

7. Schaltungsanordnung zur Wandlung eines analogen Bildsignals in ein digitales Bildsignal und zur Decodierung des digitalen Bildsignals, welche wenigstens teileweise mittels des Ausgangssignals eines Phasenregelkreises nach einem der Ansprüche 1 bis 6 getaktet wird.

8. Bildwiedergabeanordnung mit einer Schaltungsanordnung nach Anspruch 7.
